# EUROPÄISCHE PATENTSCHRIFT

(11) **EP 4 078 667 B1**
(45) Veröffentlichungstag und Bekanntmachung des Hinweises auf die Patenterteilung: **27.12.2023**
(21) Anmeldenummer: 20804202.8
(22) Anmeldetag: 09.11.2020
(51) Int. Cl.: H01L 21/683, H01L 21/67, H01L 21/762, H01L 21/304, H01L 31/18, H01L 21/78

(54) **ABLÖSEELEMENT UND VERFAHREN ZUM ABLÖSEN EINER HALBLEITERSCHICHT VON EINEM SUBSTRAT**
DETACHMENT DEVICE AND METHOD FOR DETACHING A SEMICONDUCTOR LAYER FROM A SUBSTRATE
DISPOSITIF DE DÉTACHEMENT ET MÉTHODE POUR DÉTACHER UNE COUCHE DE SEMICONDUCTEUR D'UN SUBSTRAT

(30) Priorität: 20.12.2019 DE 102019135499
(43) Veröffentlichungstag der Anmeldung: 26.10.2022
(73) Patentinhaber: Fraunhofer-Gesellschaft zur Förderung der angewandten Forschung e.V., 80686 München (DE)
(72) Erfinder: SORGENFREI, Ralf, 79110 Freiburg (DE)
(74) Vertreter: LBP Lemcke, Brommer & Partner Patentanwälte mbB
(86) Internationale Anmeldenummer: PCT/EP2020/081413
(87) Internationale Veröffentlichungsnummer: WO 2021/121769

(56) Entgegenhaltungen:
- EP-A1- 2 631 938
- JP-A- H10 233 430
- RU-C1- 2 683 808
- US-A1- 2004 168 764
- US-A1- 2008 086 874
- US-A1- 2011 088 845
- US-A1- 2015 053 352

## Beschreibung

Die Erfindung betrifft ein Ablöseelement zum Ablösen einer Halbleiterschicht von einem Substrat gemäß Anspruch 1 sowie ein Verfahren zum Ablösen einer Halbleiterschicht von einem Substrat gemäß Anspruch 10.

Bei der Herstellung von Halbleitersubstraten tritt üblicherweise ein hoher Materialverlust auf, wenn Halbleitersubstrate mittels Sägen aus einem Halbleiterblock erzeugt werden. Es sind daher Verfahren bekannt, bei welchen an einer Oberfläche eines wiederverwendbaren Trägersubstrats eine poröse Trennschicht erzeugt wird und auf der porösen Trennschicht mittels Epitaxie die Halbleiterschicht hergestellt wird. Anschließend wird die Halbleiterschicht mechanisch durch Krafteinwirkung im Bereich der porösen Trennschicht von dem Substrat abgetrennt.

Es ist bekannt, manuell ein Saugelement an der Halbleiterschicht anzuordnen und mittels Krafteinwirkung durch einen Benutzer die Halbleiterschicht zu lösen. Ein solches Verfahren ist für eine industrielle Produktion von epitaktisch hergestellten Halbleiterschichten zu aufwendig und fehleranfällig.

Aus EP 1069602 A2 ist bekannt, eine Ablösewalze über die Halbleiterschicht zu rollen, wobei die Halbleiterschicht an der Ablösewalze anhaftet und hierdurch von dem Substrat gelöst wird. Nachteilig ist hierbei, dass für eine korrekte Führung der Ablöserolle ein aufwendiges Führungssystem notwendig ist, sodass insgesamt ein hoher Platzbedarf besteht. Insbesondere ist es zur Verringerung der Bruchgefahr der Halbleiterschicht beim Ablösen typischerweise notwendig, eine Ablöserolle mit einem großen Krümmungsradius, beispielsweise im Bereich 0,5 m bis 1 m vorzusehen, um eine zu starke Biegebelastung und hierdurch verursachte Bruchefahr zu vermeiden.

Weiterer Stand der Technik wird in den Dokumenten US2011/0088845-A1, RU 2 683 808-C1 und US2017/0239927-A1 gezeigt.

Der vorliegenden Erfindung liegt daher die Aufgabe zugrunde, ein Ablöseelement und ein Verfahren zum Ablösen einer Halbleiterschicht von einem Substrat zur Verfügung zu stellen, welches bei geringerem Platzbedarf industriell einsetzbar ist.

Gelöst ist diese Aufgabe durch ein Ablöseelement zum Ablösen einer Halbleiterschicht von einem Substrat gemäß Anspruch 1 sowie ein Verfahren zum Ablösen einer Halbleiterschicht von einem Substrat gemäß Anspruch 10. Vorteilhafte Ausgestaltungen finden sich in den abhängigen Unteransprüchen. Die erfindungsgemäße Vorrichtung ist bevorzugt zur Durchführung mittels des erfindungsgemäßen Verfahrens, insbesondere einer bevorzugten Ausführungsform hiervon, ausgebildet. Das erfindungsgemäße Verfahren ist bevorzugt zur Durchführung mittels der erfindungsgemäßen Vorrichtung, insbesondere einer vorteilhaften Ausführungsform hiervon, ausgebildet.

Das erfindungsgemäße Ablöseelement dient zum Ablösen einer Halbleiterschicht von einem Substrat. Es weist zumindest eine Unterdruckkammer mit zumindest einer Absaugöffnung und zumindest einem luftdurchlässigen Ansaugbereich zum Ansaugen der Halbleiterschicht auf.

Wesentlich ist, dass die Unterdruckkammer eine flexible Kontaktwand zum Anlegen an die Halbleiterschicht aufweist und der Ansaugbereich in der Kontaktwand ausgebildet ist, dass das Ablöseelement eine Mehrzahl von zueinander beabstandeten Stützen und einen oder mehrere Aktoren aufweist, wobei die Stützen mit den der Kontaktwand zugewandten Enden an der Kontaktwand anliegen und mittels des Aktors oder Aktoren bewegbar sind und mit der Kontaktwand zusammenwirkend ausgebildet sind, um die flexible Kontaktwand zumindest in Teilbereichen zu bewegen.

Das erfindungsgemäße Ablöseelement ist somit geeignet, die Halbleiterschicht an der flexiblen Kontaktwand anzusaugen, da die flexible Kontaktwand Teil der Unterdruckkammer ist und den Ansaugbereich aufweist. Darüber hinaus kann die Kontaktwand zumindest in Teilbereichen mittels des oder der Aktoren bewegt werden.

Mittels des Ablöseelements ist es somit möglich, eine Ablösekraft auf die Halbleiterschicht einzuwirken, ohne dass eine Relativbewegung des Ablöseelements zu dem Substrat erfolgt. Es kann lediglich die flexible Kontaktwand zumindest in Teilbereichen mittels des oder der Aktoren relativ zu dem Substrat bewegt werden, um die Ablösekraft zu bewirken.

Hierdurch ist nicht nur ein platzsparender und robuster Aufbau möglich. Darüber hinaus kann durch den oder die Aktoren ein für den Ablösegang vorteilhaftes Ablösemuster der Ablösekraft erzielt werden.

Die eingangs gestellte Aufgabe ist weiterhin durch ein Verfahren zum Ablösen einer Halbleiterschicht von einem Substrat gelöst. Das Verfahren weist folgende Verfahrensschritte auf:
In einem Verfahrensschritt A erfolgt ein Bereitstellen eines Substrats mit einer an dem Substrat angeordneten Halbleiterschicht. In einem Verfahrensschritt B erfolgt ein Ablösen der Halbleiterschicht von dem Substrat.

Wesentlich ist, dass im Verfahrensschritt B eine flexible Kontaktwand an die Halbleiterschicht angelegt wird, die Halbleiterschicht an die Kontaktwand angesaugt wird und die Kontaktwand in mehrere Teilbereiche unterteilt ist, welche sukzessiv von dem Substrat entfernt werden, um die Halbleiterschicht sukzessiv von dem Substrat zu lösen.

Hierdurch wird die vorgenannte raumsparende Ausgestaltung einer entsprechenden Vorrichtung zur Durchführung dieses Verfahrens erzielt. Darüber hinaus ermöglicht das sukzessive Entfernen mehrerer Teilbereiche der Kontaktwand von dem Substrat eine vorteilhafte Wahl der Ablösebewegung und der damit auf die Halbleiterschicht einwirkenden Ablösekräfte.

Es liegt im Rahmen der Erfindung, dass die flexible Kontaktwand in zumindest einem Bereich, bevorzugt in mehreren Bereichen, außerhalb der Unterdrucckammer fortgeführt wird und insbesondere, dass eine oder mehrere Stützen in diesen Bereichen an der Kontaktwand anliegen. Dies ermöglicht einen einfacheren Austausch der Stützen und insbesondere treten etwaige Fremdkörper wie beispielsweise Schmiermittel der Stützen nicht in die Unterdruckkammer ein.

In einer weiteren vorteilhaften Ausgestaltung ist eine oder mehrere Stützen in der Unterdruckkammer angeordnet. Hierdurch ergibt sich ein konstruktiv einfacher Aufbau. Insbesondere ist es vorteilhaft, dass alle Stützen in der Unterdruckkammer angeordnet sind.

In einer vorteilhaften Weiterbildung ist zusätzlich der Aktor oder die Aktoren zum Bewegen der Stützen in der Unterdruckkammer angeordnet, sodass sich eine weitere konstruktive Vereinfachung des Aufbaus ergibt.

Die Stützen sind bevorzugt mittels des oder der Aktoren in zumindest eine erste und eine zweite Position bewegbar, wobei die Stützen derart ausgebildet und angeordnet sind, dass die der Kontaktwand zugewandten Enden der Stützwand in der ersten Position in einer ersten Ebene und in der zweiten Position in einer zweiten, zu der ersten Ebene parallelen Ebene liegen.

Hierdurch ergibt sich eine konstruktiv einfach realisierbare Ablösebewegung. Darüber hinaus weisen Stützen, die gemeinsam in der ersten Position oder gemeinsam in der zweiten Position angeordnet sind, keinen Höhenunterschied relativ zueinander auf, sodass keine oder allenfalls eine geringe Krafteinwirkung auf die Halbleiterschicht zwischen diesen Stützen erfolgt und somit die Bruchgefahr verringert wird.

Vorteilhafterweise sind die Stützen in eine Mehrzahl von Gruppen unterteilt, wobei jede Gruppe von Stützen unabhängig von der anderen Gruppe bewegbar ist. Hierdurch ist in konstruktiv einfacher Weise eine Ablösebewegung der flexiblen Kontaktwand vorgebbar, indem sukzessiv für die einzelnen Gruppen nacheinander eine Bewegung mittels dies oder Aktoren durchgeführt wird.

Hierbei ist es insbesondere vorteilhaft, dass das Ablöseelement für jede Gruppe zumindest einen, bevorzugt genau einen Aktor aufweist, um die Stützen dieser Gruppe zu bewegen.

Insbesondere ist es vorteilhaft, dass die Stützen entlang mehrerer geradliniger, paralleler Linien angeordnet sind und die entlang einer Linie angeordneten Stützen eine Gruppe bilden. Hierdurch lässt sich in einfacher Weise eine Wellenbewegung der flexiblen Kontaktwand mit einer geradlinigen Wellenfront durchführen. Eine solche Wellenbewegung ist zum bruchfreien Ablösen der Kontaktschicht von dem Trägersubstrat geeignet.

In einer vorteilhaften Weiterbildung ist jede Stütze unabhängig von den anderen Stützen bewegbar. Hierdurch lassen sich auch komplexe Ablösebewegungen der flexiblen Kontaktwand durchführen. Insbesondere ist es zum Erzielen eines konstruktiv einfachen Aufbaus vorteilhaft, dass das Ablöseelement für jede Stütze einen separaten Aktor aufweist, um die Durchführung komplexer Ablösebewegungen der flexiblen Kontaktwand insbesondere mit nicht geradlinigen Wellenfronten zu ermöglichen.

Vorteilhafterweise sind der Aktor oder die Aktoren als Stellantriebe, insbesondere als elektromagnetische oder piezoelektrische Stellantriebe, ausgebildet. Solche Stellantriebe sind an sich bekannt und können handelsüblich in kompakter Bauform erworben werden, sodass ein kostengünstiger Aufbau ohne Entwicklungsaufwand hinsichtlich der Aktoren ermöglicht wird.

Untersuchungen der Anmelderin zeigen, dass für typische Ablösevorgänge von epitaktisch aufgewachsenen Halbleiterschichten vorteilhafterweise die Stützen mittels des oder der Aktoren um einen Verfahrweg im Bereich 50 µm bis 3000 µm, insbesondere 500 µm bis 1500 µm verschiebbar sind.

Die eingangs gestellte Aufgabe ist weiterhin durch eine Ablöseeinheit zum Ablösen einer Halbleiterschicht von einem Substrat gelöst. Die Ablöseeinheit weist ein erfindungsgemäßes Ablöseelement, insbesondere eine bevorzugte Ausführungsform hiervon, auf und ein Gegenelement, welches zumindest einen luftdurchlässigen Ansaugbereich zum Ansaugen des Substrats aufweist. Hierdurch wird somit ein Ansaugen des Substrats einerseits mittels des Gegenelementes und ein Ansaugen der Halbleiterschicht andererseits mittels der flexiblen Kontaktwand des Ablöseelements ermöglicht, sodass eine Ablösekraft erzielbar ist, welche bevorzugt senkrecht zur Trennschicht zwischen Halbleiterschicht und Substrat und ausgehend von dem Substrat in Richtung der Halbleiterschicht gerichtet ist.

Vorteilhafterweise ist das Gegenelement analog zu dem Ablöseelement, insbesondere einer bevorzugten Ausführungsform hiervon, ausgebildet, wobei die flexible Kontaktwand des Gegenelementes zum Anliegen an das Substrat ausgebildet ist. Hierdurch wird ein sicheres Ansaugen auch bei unebener Substratrückseite, an welcher das Gegenelement anliegt, ermöglicht.

Bei dem erfindungsgemäßen Verfahren weisen vorteilhafterweise die Teilbereiche eine geradlinige Längserstreckung auf und die Längserstreckungen der Teilbereiche sind zueinander parallel. Hierdurch lässt sich die zuvor beschriebene, vorteilhafte Wellenbewegung mit geradliniger Wellenfront erzielen.

Typische Halbleiterschichten weisen eine im Wesentlichen rechteckige, insbesondere quadratische Form auf. Vorteilhafterweise beginnt in Verfahrensschritt E das Ablösen im Bereich einer Ecke der Halbleiterschicht. Hierdurch wird eine vorteilhafte Ablösebewegung erzielt, welche die Bruchgefahr verringert. Ebenso kann das erfindungsgemäße Ablöseelement und das erfindungsgemäße Verfahren zur Anwendung bei anderen Formen von Halbleiterschichten, insbesondere runde Formen ausgebildet sein. Hierbei ist bevorzugt der Ansaugbereich auf die Form der abzulösenden Halbleiterschicht angepasst, d.h. bevorzugt kleiner oder gleich groß wie die abzulösende Halbleiterschicht, so dass keine Luft in einem nicht von der Halbleiterschicht bedeckten Bereich des Ansaugbereiches in die Unterdruckkammer eintritt.

Im Falle von runden Formen der Halbleiterschicht beginnt im Verfahrensschritt E bevorzugt das Ablösen bevorzugt an einer Ecke der sog. Flat (abgeflachte Seite des zugehörigen Substrats zur Identifikation der kristallographischen Orientierung) oder Notch (in das zugehörige Substrat eingefräste Kerbe zur Identifikation der kristallographischen Orientierung), falls solche Markierungen vorhanden sind. Vorteilhafterweise werden zum Ablösen die Teilbereiche der Kontaktwand um eine Strecke im Bereich 50 µm bis 3000 µm, insbesondere 500 µm bis 1500 µm bewegt.

Das Ablösen mittels des erfindungsgemäßen Verfahrens, insbesondere einer bevorzugten Ausführungsform hiervon, erfolgt bevorzugt mittels eines erfindungsgemäßen Ablöseelementes, insbesondere mittels der zuvor beschriebenen Ablöseeinheit.

Die Halbleiterschicht wird bevorzugt epitaktisch auf das Substrat aufgebracht. Vorteilhafterweise wird zunächst auf einer Oberfläche des Substrats eine poröse Trennschicht erzeugt, insbesondere bevorzugt in an sich bekannter Weise mittels Ätzen und anschließend epitaktisch die Halbleiterschicht auf der Trennschicht ausgebildet.

Der luftdurchlässige Ansaugbereich von Ablöseelement und/oder Gegenelement weist bevorzugt eine Mehrzahl von Ansaugöffnungen auf. Durch die Ansaugöffnungen kann Luft in die Unterdruckkammer gesaugt und somit die Halbleiterschicht an die flexible Kontaktwand von Ablöseelement und/oder Gegenelement angesaugt werden. In einer alternativen vorteilhaften Ausführungsform ist der luftdurchlässige Ansaugbereich von Ablöseelement und/oder Gegenelement als poröser Bereich ausgebildet, so dass Luft durch den porösen Bereich hindurchtreten kann und hierdurch ein Ansaugen ermöglicht wird. Ebenso liegt die Kombination durch Ausbilden eines porösen Ansaugbereiches, welcher zusätzlich Ansaugöffnungen aufweist, im Rahmen der Erfindung.

Weitere vorteilhafte Merkmale und Ausführungsformen werden im Folgenden anhand von Ausführungsbeispielen und den Figuren erläutert. Dabei zeigt:
- Figur 1: eine Teilschnittdarstellung eines ersten Ausführungsbeispiels des erfindungsgemäßen Ablöseelements;
- Figur 2: eine Schnittdarstellung senkrecht zur Figurenebene in Figur 1;
- Figur 3: Teilschritte eines Ausführungsbeispiels des erfindungsgemäßen Verfahrens zum Ablösen einer Halbleiterschicht von einem Substrat mittels des in Figur 1 dargestellten ersten Ausführungsbeispiels eines Ablöseelements;
- Figur 4: ein zweites Ausführungsbeispiel eines erfindungsgemäßen Ablöseelementes und ein Ausführungsbeispiel einer erfindungsgemäßen Ablöseeinheit.

Sämtliche Figuren zeigen schematische, nicht maßstabsgetreue Darstellungen. Gleiche Bezugszeichen in den Figuren bezeichnen gleiche oder gleichwirkende Elemente.

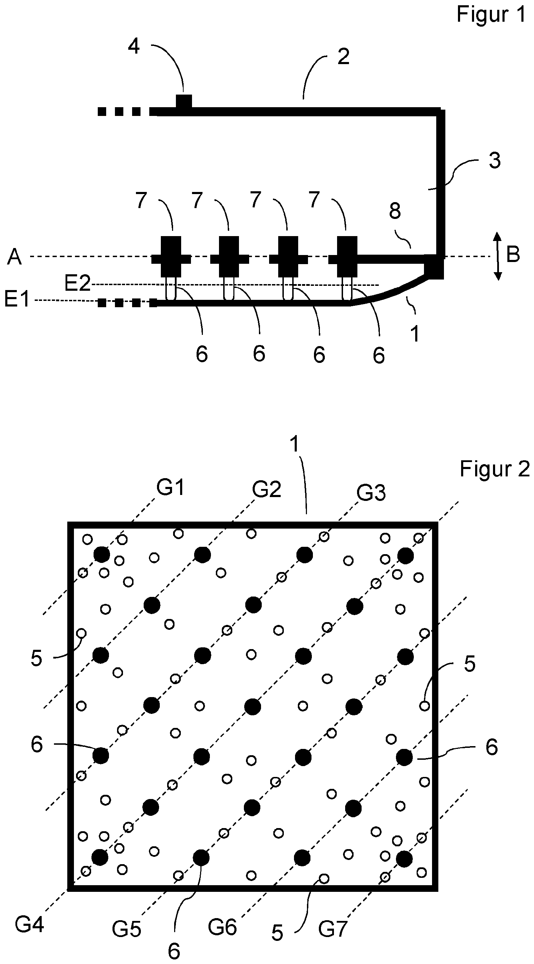

In Figur 1 ist ein erstes Ausführungsbeispiel eines erfindungsgemäßen Ablöseelementes gezeigt. Dargestellt ist ein Teil einer Schnittdarstellung mit einer Schnittebene senkrecht zu einer flexiblen Kontaktwand 1 des Ablöseelements. Die flexible Kontaktwand 1 ist randseitig mit einem Gehäuse 2 des Ablöseelementes verbunden, sodass in dem Gehäuse 2 eine Unterdruckkammer 3 ausgebildet ist, welche durch die Wände des Gehäuses 2 sowie durch die flexible Kontaktwand 1 begrenzt ist.

Zur besseren Darstellbarkeit ist in den Figuren 1, 3 und 4 jeweils nur ein rechter Teilbereich der Schnittdarstellung gezeigt. Das Ablöseelement setzt sich jeweils nach links fort, wie durch die Punktlinien angedeutet.

Das Ablöseelement weist eine Absaugöffnung 4 auf, welche bei dem vorliegenden Ausführungsbeispiel an einer oberen Wand des Gehäuses 2 ausgebildet ist. Durch Absaugen von Luft durch die Absaugöffnung 4 aus der Unterdruckkammer 3 kann ein Unterdruck in der Unterdruckkammer hergestellt werden.

Die flexible Kontaktwand 1 weist eine Mehrzahl von Ansaugöffnungen 5 auf, wie in Figur 2 ersichtlich:
Figur 2 zeigt eine Draufsicht von unten auf die flexible Kontaktwand 1. Die flexible Kontaktwand 1 weist eine quadratische Form auf mit einer Vielzahl von Ansaugöffnungen 5, welche als offene Kreise dargestellt sind. Aus Gründen der Übersichtlichkeit sind exemplarisch lediglich drei Ansaugöffnungen mit Bezugszeichen 5 gekennzeichnet. Die von den Ansaugöffnungen 5 abgedeckte Fläche der flexiblen Kontaktwand 1 bildet somit einen luftdurchlässigen Ansaugbereich aus, zum Ansaugen einer Halbleiterschicht:
Bei Auflegen der flexiblen Kontaktwand 1 auf eine Halbleiterschicht kann somit durch Absaugen an der Absaugöffnung 4 und somit Erzeugen eines Unterdrucks in der Unterdruckkammer 3 die Halbleiterschicht an die flexible Kontaktwand 1 mittels der Ansaugöffnungen 5 angesaugt werden.

In einer alternativen Ausführungsform dieses Ausführungsbeispiels ist die flexible Kontaktwand 1 in dem Ansaugbereich porös und somit luftdurchlässig ausgebildet. Die poröse Ausbildung stellt somit eine alternative Ausbildung des luftdurchlässigen Ansaugbereiches zu der Ausbildung mit Ansaugöffnungen dar. Ebenso können Ansaugöffnungen in einem porösen Ansaugbereich ausgebildet werden.

Die Halbleiterschicht kann als an sich bekannte Halbleiterschicht ausgebildet sein, insbesondere als Siliziumschicht, Germaniumschicht oder eine mehrlagige Schicht. Das Substrat ist bevorzugt ein Halbleitersubstrat.

Insbesondere sind die erfindungsgemäße Ablöseeinheit und das erfindungsgemäße Verfahren zum Ablösen einer Siliziumschicht geeignet, welche auf einem Siliziumsubstrat erzeugt wurde. Ebenso liegt die Verwendung für andere Halbleiterschichten, insbesondere eine Halbleiterschicht, welche auf einem Germaniumsubstrat erzeugt wurde, im Rahmen der Erfindung, beispielsweise epitaktisch erzeugte Germaniumschichten oder III/V Verbindungshalbleiterschichten auf einem porosiziertem Germanium-Wafer als Substrat.

Wie in Figur 1 ersichtlich, weist das Ablöseelement eine Mehrzahl von zueinander beabstandeter Stützen 6 auf. Die Stützen 6 liegen mit den der Kontaktwand 1 zugewandten Enden an der Kontaktwand 1 an.

Das Ablöseelement gemäß Figur 1 weist weiterhin für jede der Stützen 6 jeweils einen Aktor 7 auf. Jeder Aktor ist als elektrischer Linearaktor ausgebildet.

Mittels der Aktoren 7 können die Stützen 6 somit linear geradlinig in der mit B in Figur 1 gekennzeichneten Richtung auf und ab bewegt werden.

Die Stützen sind somit mittels der Aktoren bewegbar und mit der Kontaktwand zusammenwirkend ausgebildet, sodass die flexible Kontaktwand 1 selektiv in Teilbereichen durch Verfahren der Stützen bewegt werden kann.

Die Aktoren 7 sind an einer Lochplatte 8 angeordnet, welche mit dem Gehäuse 2 des Ablöseelementes verbunden ist. Hierdurch sind die Aktoren 7 starr relativ zu dem Gehäuse 2 angeordnet. Durch die Löcher der Lochplatte 8 kann jedoch Fluid bis zu der flexiblen Kontaktwand 1 hindurchtreten, sodass sich die Unterdruckkammer 3 bis zu der flexiblen Kontaktwand 1 erstreckt.

In Figur 2 sind zur besseren Verständlichkeit die Auflagepunkte der Stützen 6 an der flexiblen Kontaktwand 1 durch geschlossene Kreise gekennzeichnet. Auch hier sind zur besseren Übersichtlichkeit lediglich drei geschlossene Kreise durch Bezugszeichen 6 gekennzeichnet.

In Figur 1 ersichtlich, sind bei dem gezeigten ersten Ausführungsbeispiel sowohl die Stützen 6 als auch die Aktoren 7 in der Unterdruckkammer 3 angeordnet.

Mittels der Aktoren 7 sind die Stützen 6 in zumindest eine erste und eine zweite Position bewegbar. Die Stützen 6 sind dabei derart ausgebildet und angeordnet, dass die der Kontaktwand zugewandten Enden der Stützen in der ersten Position in einer ersten Ebene E1 und in der zweiten Position in einer zweiten Ebene E2 liegen. In Figur 1 stehen diese Ebenen senkrecht zur Zeichenebene und sind durch die Bezugszeichen E1 und E2 gekennzeichnet. Wie in Figur 1 ersichtlich, ist der Zustand dargestellt, bei welchem alle Aktoren ausgefahren sind, sodass die der flexiblen Kontaktwand 1 zugewandten Enden aller Stützen 6 sich in der Ebene E1 befinden und sich somit auch die flexible Kontaktwand 1 im Bereich der Stützen 6 in der Ebene E1 befindet.

Die Ebene E1 ist parallel zu der Ebene E2 und zu dieser um 1000 µm beabstandet.

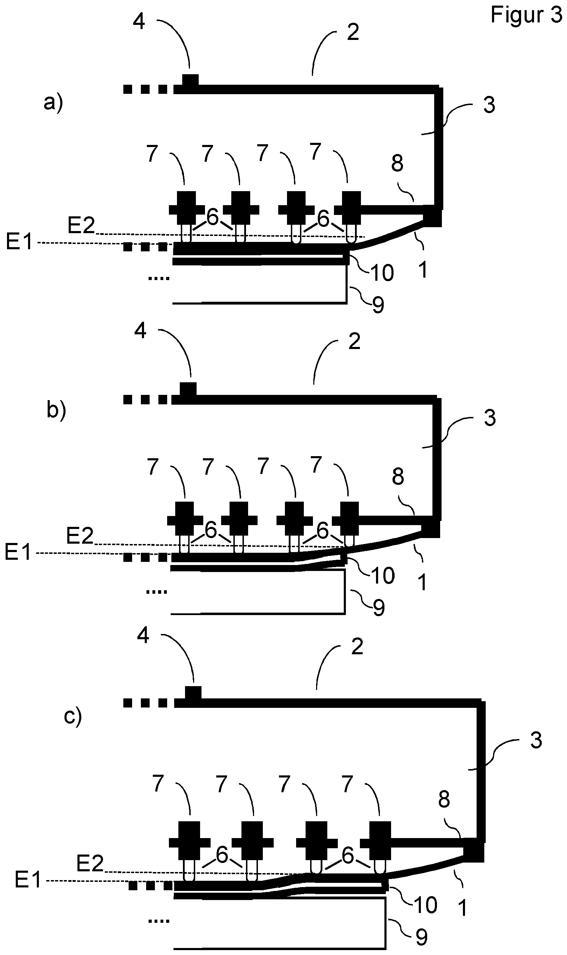

In Figur 3 sind Teilschritte eines Ausführungsbeispiels eines erfindungsgemäßen Verfahrens zum Ablösen einer Halbleiterschicht von einem Substrat mittels des in Figur 1 gezeigten Ablöseelementes dargestellt.

In einem Verfahrensschritt A wird ein Substrat 9 bereitgestellt. Das Substrat 9 ist als Halbleiterwafer ausgebildet, vorliegend als Siliziumwafer ausgebildet, an dessen Vorderseite, welche in den Figuren stets oben liegend dargestellt ist, mittels Ätzen eine poröse Trennschicht ausgebildet wurde. Mittels Epitaxie wurde in an sich bekannter Weise eine Halbleiterschicht 10 auf der porösen Schicht des Substrats 9 ausgebildet. Die Herstellung der Halbleiterschicht 10 erfolgte in an sich bekannter Weise unter der Verwendung von Silan, sodass die Halbleiterschicht 10 als Siliziumschicht ausgebildet ist.

In einem Verfahrensschritt B erfolgt nun ein Ablösen der Halbleiterschicht 10 von dem Substrat 9, wie in den Teilfiguren a bis c der Figur 3 gezeigt:
Zunächst werden alle Stützen in die Position E1 gefahren. Anschließend wird das Ablöseelement mit der flexiblen Kontaktwand 1 an der dem Substrat 9 abgewandten Seite der Halbleiterschicht 10 angeordnet. Mittels Absaugen durch die Absaugöffnung 4 wird in der Unterdruckkammer 3 ein Unterdruck erzeugt, sodass aufgrund der in der flexiblen Kontaktwand 1 ausgebildeten Ansaugöffnungen 5 die Halbleiterschicht 10 an die flexible Kontaktwand 1 und somit an das Ablöseelement angesaugt wird. Dies ist in Figur 3a dargestellt.

Anschließend werden Teilbereiche der flexiblen Kontaktwand 1 sukzessive von dem Substrat 9 entfernt, um die Halbleiterschicht 10 sukzessiv von dem Substrat 9 zu lösen. In der Darstellung gemäß Figur 3 werden sukzessiv die Stützen 6 von rechts nach links abfolgend jeweils von der Position E1 in die Position E2 verfahren.

In Figur 3b ist ein Zwischenzustand dargestellt, bei welchem lediglich die rechte Stütze 6 mittels des zugeordneten Aktors 7 in die Position E2 verfahren wurde. Aufgrund des Unterdrucks in der Unterdruckkammer 3 bewegt sich auch die flexible Kontaktwand 1 in demjenigen Teilbereich, welcher an der rechten Stütze 6 anliegt, nach oben in die Position E2. Hierdurch löst sich die Halbleiterschicht 10 im rechten Randbereich von dem Substrat 9.

Anschließend wird die benachbarte Stütze, das heißt die zweite Stütze von rechts, in die Position E2 verfahren, sodass sich auch in diesem Bereich die Halbleiterschicht 10 von dem Substrat 9 löst. Dies ist in Figur 3c dargestellt. Sukzessive werden nun nacheinander alle Stützen 6 in die Position E2 verfahren, sodass schließlich die Halbleiterschicht 10 vollständig von dem Substrat 9 gelöst ist.

Die Stützen sind hierbei in mehrere Gruppen unterteilt, wie in Figur 2 ersichtlich. Jede Gruppe von Stützen ist unabhängig von den anderen Gruppen bewegbar, bei dem vorliegenden Ausführungsbeispiel dadurch, dass jede Stütze einem eigenen Aktor zugeordnet ist. In einer Abwandlung des Ausführungsbeispiels sind die Stützen über Stangen mechanisch gekoppelt, sodass jede Gruppe mittels eines Aktors aus der Position E1 in die Position E2 und umgekehrt bewegt werden kann.

Die Stützen 6 sind entlang mehrerer geradliniger, paralleler Linien angeordnet und die entlang einer Linie angeordneten Aktoren zu diesen Stützen bilden eine Gruppe.

Wie in Figur 2 ersichtlich, verlaufen die gestrichelt dargestellten parallelen Linien, welche die Gruppen definieren, diagonal zu der quadratischen Ausgestaltung der flexiblen Kontaktwand 1. Bei dem in Figur 2 dargestellten Ausführungsbeispiel liegen somit sieben Gruppen G1 bis G7 vor, wobei die Gruppen G1 und G7 jeweils lediglich eine Stütze 6 mit zugeordnetem Aktor 7 umfassen.

Bei dem Ablösevorgang befinden sich zunächst die Stützen 6 aller Gruppen G1 bis G7 in der ersten Position, sodass deren Enden sich in der Ebene E1 befinden.

Nun werden in aufsteigender Folge zunächst die Aktoren der Gruppe G1, anschließend der Gruppe G2 und weiterfolgend bis zur Gruppe G7 sukzessive in die Position E2 verfahren, sodass der in Figur 3 gezeigte Ablösevorgang der Halbleiterschicht 10 von den Substraten 9 ausgehend von der in Figur 2 links oben liegenden Ecke bis zu der in Figur 2 rechts unten liegenden Ecke erfolgt. Die flexible Kontaktwand 1 führt somit eine Wellenbewegung durch, wobei die Wellenfront parallel zu den in Figur 2 gestrichelt dargestellten geraden Linien verläuft, welche die Gruppen G1 bis G7 markieren.

In Figur 1 ist ersichtlich, dass die flexible Kontaktwand 1 am Rand mit dem Gehäuse 2 in einer Position verbunden ist, welche in etwa in der Ebene E2 liegt.

Hierdurch ergibt sich eine kostengünstige Ausgestaltung, allerdings besteht in dem Zustand, in welchem alle Stützen in die Position 1 gefahren sind und deren Enden sich somit in der Ebene E1 befinden, aufgrund Spannungseinwirkung der flexiblen Kontaktwand 1 eine deutliche Krafteinwirkung auf die rechte Stütze 6 in Figur 1. Durch Wahl eines entsprechend robusten Aktors kann auch in dieser Konfiguration ein dauerhafter Betrieb gewährleistet werden.

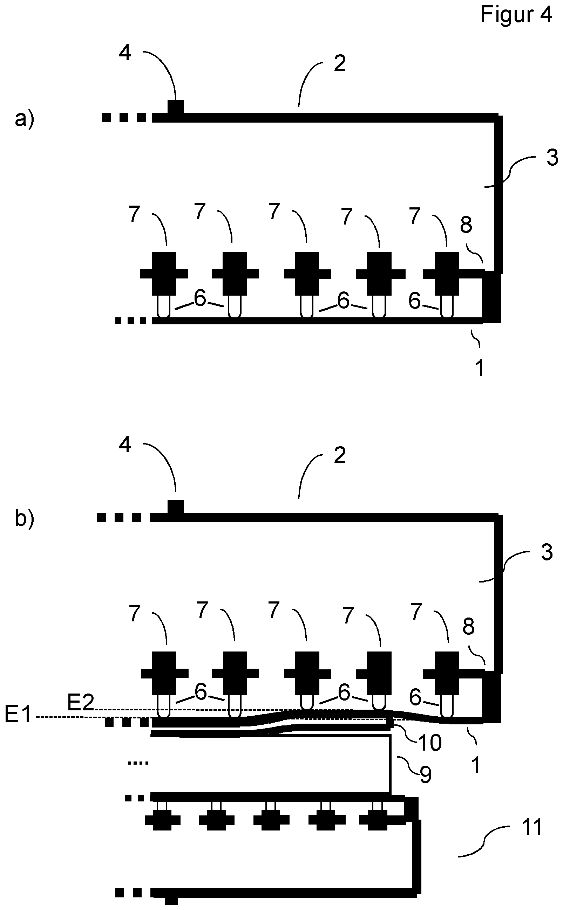

Figur 4 zeigt als zweites Ausführungsbeispiel eines Ablöseelementes eine Abwandlung zu dem in den Figuren 1 bis 3 gezeigten ersten Ausführungsbeispiel eines Ablöseelementes.

Das zweite Ausführungsbeispiel ist weitgehend gleich zu dem ersten Ausführungsbeispiel ausgebildet. Zur Vermeidung von Wiederholungen wird daher im Folgenden lediglich auf die wesentlichen Unterschiede eingegangen:
Wie in Figur 4 ersichtlich, ist die flexible Kontaktwand 1 am Rand mit dem Gehäuse 2 in einer Position verbunden, welche den ausgefahrenen Stützen 6 in der ersten Position entspricht, das heißt der Verbindungsort zwischen flexibler Kontaktwand 1 und Gehäuse 2 liegt in etwa in der Ebene E1.

Werden nun die Stützen 6 eingefahren, sodass sich deren Enden in der Position E2 befinden, so wirkt auf die randständigen Stützen und zugeordneten Aktoren eine geringere Kraft verglichen mit dem ersten Ausführungsbeispiel.

In Figur 4b ist schließlich ein Ausführungsbeispiel einer erfindungsgemäßen Ablöseeinheit dargestellt. Die Ablöseeinheit weist vorliegend ein Ablöseelement gemäß Figur 4a auf, das heißt gemäß des zweiten Ausführungsbeispiels. Zusätzlich weist die Ablöseeinheit ein Gegenelement 11 auf. Dieses Gegenelement 11 ist analog zu dem zweiten Ausführungsbeispiel eines Ablöseelementes gemäß Figur 4a ausgebildet, jedoch spiegelverkehrt angeordnet.

Wie in Figur 4b ersichtlich, kann während des Ablösevorgangs somit mittels des oberen Ablöseelementes analog zu der Darstellung in Figur 3 sukzessive vom rechten Rand ausgehend die Halbleiterschicht 10 von dem Substrat 9 gelöst werden. Gleichzeitig wird das Substrat 9 mittels des Gegenelementes 11 fixiert.

Der Schutzbereich des europäischen Patents wird durch die Patentansprüche bestimmt.

### Bezugszeichenliste

- 1: flexible Kontaktwand
- 2: Gehäuse
- 3: Unterdruckkammer
- 4: Absaugöffnung
- 5: Ansaugöffnungen
- 6: Stützen
- 7: Aktor
- 8: Lochplatte
- 9: Substrat
- 10: Halbleiterschicht
- 11: Gegenelement

## Patentansprüche

1. Ablöseelement zum Ablösen einer Halbleiterschicht (10) von einem Substrat (9),
mit zumindest einer Unterdruckkammer (3) mit zumindest einer Absaugöffnung (4) und zumindest einem luftdurchlässigen Ansaugbereich zum Ansaugen der Halbleiterschicht (10), wobei
die Unterdruckkammer eine flexible Kontaktwand (1) zum Anlegen an die Halbleiterschicht (10) aufweist und der Ansaugbereich in der Kontaktwand ausgebildet ist,
wobei das Ablöseelement eine Mehrzahl von zueinander beabstandeten Stützen (6) und einen oder mehrere Aktoren (7) aufweist, wobei die Stützen (6) mit den der Kontaktwand zugewandten Enden an der Kontaktwand anliegen und mittels des Aktors (7) oder der Aktoren (7) bewegbar und mit der Kontaktwand zusammenwirkend ausgebildet sind, um die flexible Kontaktwand (1) zumindest in Teilbereichen zu bewegen.

2. Ablöseelement nach Anspruch 1,
**dadurch gekennzeichnet,**
**dass** die Stützen (6) in der Unterdruckkammer (3) angeordnet sind, insbesondere, dass die Stützen (6) und der Aktor (7) oder die Aktoren (7) zum Bewegen der Stützen (6) in der Unterdruckkammer (3) angeordnet sind.

3. Ablöseelement nach Anspruch 1,
**dadurch gekennzeichnet**,
die Stützen (6) mittels des oder der Aktoren (7) in zumindest eine erste und eine zweite Position bewegbar sind, wobei die Stützen (6) derart ausgebildet und angeordnet sind, dass die der Kontaktwand zugewandten Enden der Stützwand in der ersten Position in einer ersten Ebene und in der zweiten Position in einer zweiten, zu der ersten Ebene parallele Ebene liegen.

4. Ablöseelement nach einem der vorangegangen Ansprüche,
**dadurch gekennzeichnet,**
**dass** die Stützen (6) in eine Mehrzahl von Gruppen untereilt sind, wobei jede Gruppe von Stützen (6) unabhängig von den anderen Gruppen bewegbar ist, insbesondere, dass das Ablöseelement für jede Gruppe zumindest einen, bevorzugt genau einen Aktor (7) aufweist, um die Stützen (6) dieser Gruppe zu bewegen,
bevorzugt, dass jede Stütze (6) unabhängig von den anderen Stützen (6) bewegbar ist, insbesondere, dass das Ablöseelement für jede Stütze einen separaten Aktor (7) aufweist.

5. Ablöseelement nach Anspruch 4,
**dadurch gekennzeichnet,**
**dass** die Stützen (6) entlang mehrerer geradliniger, paralleler Linien angeordnet sind und die entlang einer Linie angeordneten Aktoren (7) eine Gruppe bilden.

6. Ablöseelement nach einem der vorangegangenen Ansprüche,
**dadurch gekennzeichnet,**
**dass** der oder die Aktoren (7) als Stellantriebe, insbesondere als elektromagnetische Stellantriebe ausgebildet sind.

7. Ablöseelement nach einem der vorangegangenen Ansprüche,
**dadurch gekennzeichnet**,
die Stützen (6) mittels des oder der Aktoren (7) um einen Verfahrweg im Bereich 50 µm bis 3000 µm, insbesondere 500 µm bis 1500 µm verschiebbar sind.

8. Ablöseeinheit zum Ablösen zum Ablösen einer Halbleiterschicht (10) von einem Substrat (9),
mit einem Ablöseelement nach einem der vorangegangenen Ansprüche und mit einem Gegenelement, welches zumindest einen luftdurchlässigen Ansaugbereich zum Ansaugen des Substrats aufweist.

9. Ablöseeinheit nach Anspruch 8,
**dadurch gekennzeichnet,**
**dass** das Gegenelement (11) wie ein Ablöseelement gemäß einem der Ansprüche 1 bis 7 ausgebildet ist, wobei die flexible Kontaktwand (1) des Gegenelements zum Anlegen an das Substrat (9) ausgebildet ist.

10. Verfahren zum Ablösen einer Halbleiterschicht (10) von einem Substrat, mit den Verfahrensschritten
A. Bereitstellen eines Substrats (9), mit einer an dem Substrat (9) angeordneten Halbleiterschicht (10),
B. Ablösen der Halbleiterschicht (10) von dem Substrat (9),
wobei in Verfahrensschritt B eine flexible Kontaktwand (1) an die Halbleiterschicht (10) angelegt wird, die Halbleiterschicht (10) an die Kontaktwand angesaugt wird und die Kontaktwand in mehrere Teilbereiche unterteilt ist, welche sukzessiv von dem Substrat (9) entfernt werden, um die Halbleiterschicht (10) sukzessiv von dem Substrat (9) zu lösen.

11. Verfahren nach Anspruch 10,
**dadurch gekennzeichnet,**
**dass** die Teilbereiche eine geradlinige Längserstreckung aufweisen und die Längserstreckungen der Teilbereiche parallel zueinander sind.

12. Verfahren nach einem der Ansprüche 10 bis 11,
**dadurch gekennzeichnet,**
**dass** die Halbleiterschicht (10) eine im Wesentlichen rechteckige, insbesondere quadratische Form aufweist und im Bereich einer Ecke der Halbleiterschicht (10) das Ablösen in Verfahrensschritt B beginnt.

13. Verfahren nach einem der Ansprüche 10 bis 12,
**dadurch gekennzeichnet,**
**dass** zum Ablösen die Teilbereiche der Kontaktwand um eine Strecke im Bereich 50 µm bis 3000 µm, insbesondere 500 µm bis 1500 µm entfernt werden.

14. Verfahren nach einem der Ansprüche 10 bis 13,
**dadurch gekennzeichnet,**
**dass** das Ablösen mittels eines Ablöseelements gemäß einem der Ansprüche 1 bis 7, insbesondere mittels einer Ablöseeinheit gemäß einem der Ansprüche 8 bis 9 erfolgt.

15. Verfahren nach einem der Ansprüche 10 bis 14,
**dadurch gekennzeichnet,**
**dass** die Halbleiterschicht (10) epitaktisch auf das Substrat (9) aufgebracht wird, insbesondere, dass an dem Substrat (9) eine Trennschicht ausgebildet wird und die Halbleiterschicht (10) auf die Trennschicht aufgebracht wird.

## Claims

1. Detachment device for detaching a semiconductor layer (10) from a substrate (9),
having at least one vacuum chamber (3) with at least one exhaust opening (4) and at least one air-permeable suction region for applying suction to the semiconductor layer (10), wherein
the vacuum chamber has a flexible contact wall (1) for application to the semiconductor layer (10), and the suction region is formed in the contact wall,
wherein the detachment device has a plurality of mutually spaced supports (6) and one or more actuators (7), the supports (6) being in contact with the contact wall by their ends that face towards the contact wall and being configured to be movable by means of the actuator (7) or actuators (7) and to co-operate with the contact wall in order to move the flexible contact wall (1) at least in sub-regions.

2. Detachment device according to claim 1,
**characterised in that**
the supports (6) are arranged in the vacuum chamber (3); especially, the supports (6) and the actuator (7) or actuators (7) for moving the supports (6) are arranged in the vacuum chamber (3).

3. Detachment device according to claim 1,
**characterised in that**
the supports (6) are movable by means of the actuator(s) (7) into at least a first position and a second position, the supports (6) being configured and arranged in such a way that the ends of the support wall that face towards the contact wall are, in the first position, located in a first plane and, in the second position, located in a second plane parallel to the first plane.

4. Detachment device according to any one of the preceding claims,
**characterised in that**
the supports (6) are divided into a plurality of groups, each group of supports (6) being movable independently of the other groups; especially, the detachment device has at least one actuator, preferably just one actuator (7), for each group in order to move the supports (6) of that group;
preferably, each support (6) is movable independently of the other supports (6); especially, the detachment device has a separate actuator (7) for each support.

5. Detachment device according to claim 4,
**characterised in that**
the supports (6) are arranged along a plurality of rectilinear, parallel lines and the actuators (7) arranged along a line form a group.

6. Detachment device according to any one of the preceding claims,
**characterised in that**
the actuator(s) (7) are configured as actuating drives, especially as electromagnetic actuating drives.

7. Detachment device according to any one of the preceding claims,
**characterised in that**
the supports (6) are displaceable by means of the actuator(s) (7) through a travel path in the range of from 50 µm to 3000 µm, especially from 500 µm to 1500 µm.

8. Detachment unit for detaching a semiconductor layer (10) from a substrate (9),
having a detachment device according to any one of the preceding claims and having a counterpart device which has at least one air-permeable suction region for applying suction to the substrate.

9. Detachment unit according to claim 8,
**characterised in that**
the counterpart device (11) is constructed in the same way as a detachment device according to any one of claims 1 to 7, the flexible contact wall (1) of the counterpart device being configured for application to the substrate (9).

10. Method for detaching a semiconductor layer (10) from a substrate, having the method steps
A. provision of a substrate (9), with a semiconductor layer (10) arranged on the substrate (9),
B. detachment of the semiconductor layer (10) from the substrate (9), wherein in method step B a flexible contact wall (1) is applied to the semiconductor layer (10), the semiconductor layer (10) is drawn against the contact wall by suction, and the contact wall is divided into a plurality of sub-regions which are successively moved away from the substrate (9) in order to release the semiconductor layer (10) successively from the substrate (9).

11. Method according to claim 10,
**characterised in that**
the sub-regions have a rectilinear longitudinal extent and the longitudinal extents of the sub-regions are parallel to one another.

12. Method according to either one of claims 10 and 11,
**characterised in that**
the semiconductor layer (10) has a substantially rectangular shape, especially a square shape, and in method step B the detachment begins in the region of a corner of the semiconductor layer (10).

13. Method according to any one of claims 10 to 12,
**characterised in that**
for the detachment, the sub-regions of the contact wall are moved away by a distance in the range of from 50 µm to 3000 µm, especially from 500 µm to 1500 µm.

14. Method according to any one of claims 10 to 13,
**characterised in that**
the detachment is effected by means of a detachment device according to any one of claims 1 to 7, especially by means of a detachment unit according to either one of claims 8 and 9.

15. Method according to any one of claims 10 to 14,
**characterised in that**
the semiconductor layer (10) is applied epitaxially to the substrate (9); especially, a separating layer is formed on the substrate (9) and the semiconductor layer (10) is applied to the separating layer.

## Revendications

1. Élément de détachement pour détacher une couche semi-conductrice (10) d'un substrat (9),
comprenant au moins une chambre à dépression (3) comportant au moins une ouverture d'extraction par aspiration (4) et au moins une zone d'aspiration perméable à l'air pour aspirer la couche semi-conductrice (10), dans lequel
la chambre à dépression présente une paroi de contact souple (1) pour application contre la couche semi-conductrice (10) et la zone d'aspiration est réalisée dans la paroi de contact,
dans lequel
l'élément de détachement présente une pluralité de supports (6) espacés les uns des autres et un ou plusieurs actionneurs (7), dans lequel les supports (6) reposent avec les extrémités tournées vers la paroi de contact contre la paroi de contact et sont déplaçables au moyen de l'actionneur (7) ou des actionneurs (7) et réalisés en interaction avec la paroi de contact afin de déplacer la paroi de contact souple (1) au moins dans des zones partielles.

2. Élément de détachement selon la revendication 1,
**caractérisé en ce que**
les supports (6) sont disposés dans la chambre à dépression (3), en particulier que les supports (6) et l'actionneur (7) ou les actionneurs (7) sont disposés dans la chambre à dépression (3) pour déplacer les supports (6).

3. Élément de détachement selon la revendication 1,
**caractérisé en ce que**
les supports (6) sont déplaçables au moyen du ou des actionneurs (7) dans au moins une première et une deuxième position, dans lequel les supports (6) sont réalisés et disposés de manière que les extrémités tournées vers la paroi de contact de la paroi de support se trouvent en première position dans un premier plan et en deuxième position dans un deuxième plan parallèle au premier plan.

4. Élément de détachement selon l'une quelconque des revendications précédentes,
**caractérisé en ce que**
les supports (6) sont divisés en une pluralité de groupes, dans lequel chaque groupe de supports (6) est déplaçable indépendamment des autres groupes, en particulier que l'élément de détachement pour chaque groupe présente au moins un, de préférence exactement un, actionneur(7) afin de déplacer les supports (6) de ce groupe,
de préférence que chaque support(6) est déplaçable indépendamment des autres supports (6), en particulier que l'élément de détachement présente un actionneur (7) séparé pour chaque support.

5. Élément de détachement selon la revendication 4,
**caractérisé en ce que**
les supports (6) sont disposés le long de plusieurs lignes rectilignes parallèles et les actionneurs (7) disposés le long d'une ligne forment un groupe.

6. Élément de détachement selon l'une quelconque des revendications précédentes,
**caractérisé en ce que**
le ou les actionneurs (7) sont réalisés en tant que servomoteurs, en particulier en tant que servomoteurs électromagnétiques.

7. Élément de détachement selon l'une quelconque des revendications précédentes,
**caractérisé en ce que**
les supports (6) peuvent être déplacés au moyen du ou des actionneurs (7) d'une course de déplacement dans la plage de 50 µm à 3 000 µm, en particulier de 500 µm à 1 500 µm.

8. Unité de détachement pour détacher une couche semi-conductrice (10) d'un substrat (9),
comprenant un élément de détachement selon l'une quelconque des revendications précédentes et comprenant un contre-élément qui présente au moins une zone d'aspiration perméable à l'air pour l'aspiration du substrat.

9. Unité de détachement selon la revendication 8,
**caractérisé en ce que**
le contre-élément (11) est réalisé en tant qu'élément de détachement selon l'une quelconque des revendications 1 à 7, dans lequel la paroi de contact souple (1) du contre-élément est réalisée pour application contre le substrat (9).

10. Procédé de détachement d'une couche semi-conductrice (10) d'un substrat, comprenant les étapes de procédé
A. préparation d'un substrat (9) comprenant une couche semi-conductrice (10) disposée sur le substrat (9),
B. détachement de la couche semi-conductrice (10) du substrat (9),
dans lequel
à l'étape de procédé B, une paroi de contact souple (1) est appliquée contre la couche semi-conductrice (10), la couche semi-conductrice (10) est aspirée en la paroi de contact et la paroi de contact est divisée en plusieurs zones partielles qui sont successivement enlevées du substrat (9) afin de détacher successivement la couche semi-conductrice (10) du substrat (9).

11. Procédé selon la revendication 10,
**caractérisé en ce que**
les zones partielles présentent une étendue longitudinale rectiligne et les étendues longitudinales des zones partielles sont parallèles les unes aux autres.

12. Procédé selon l'une quelconque des revendications 10 à 11,
**caractérisé en ce que**
la couche semi-conductrice (10) présente une forme sensiblement rectangulaire, en particulier carrée et le détachement commence à l'étape de procédé B dans la zone d'un coin de la couche semi-conductrice (10).

13. Procédé selon l'une quelconque des revendications 10 à 12,
**caractérisé en ce que**
pour le détachement, les zones partielles de la paroi de contact sont enlevées sur une distance dans la plage de 50 µm à 3 000 µm, en particulier de 500 µm à 1 500 µm.

14. Procédé selon l'une quelconque des revendications 10 à 13,
**caractérisé en ce que**
le détachement s'effectue au moyen d'un élément de détachement selon l'une quelconque des revendications 1 à 7, en particulier au moyen d'une unité de détachement selon l'une quelconque des revendications 8 à 9.

15. Procédé selon l'une quelconque des revendications 10 à 14,
**caractérisé en ce que**
la couche semi-conductrice (10) est appliquée de manière épitaxiale sur le substrat (9), en particulier qu'une couche de séparation est réalisée sur le substrat (9) et la couche semi-conductrice (10) est appliquée sur la couche de séparation.
